# EUROPEAN PATENT APPLICATION

(11) **EP 4 307 560 A1**
(43) Date of publication of application: **17.01.2024**
(21) Application number: 22184653.8
(22) Date of filing: 13.07.2022
(51) Int. Cl.: H03C 5/00, H03C 1/62, H03C 3/09, H04L 27/20

(54) **POLAR TRANSMITTER APPARATUS AND CORRESPONDING METHOD FOR REALIZING FAST PHASE CHANGES AND PHASE JUMPS**

(71) Applicant: Shenzhen Goodix Technology Co., Ltd., Shenzhen, Guangdong 518045 (CN)
(72) Inventor: Fliess, Thomas, 01099 Dresden (DE); Emira, Ahmed, San Diego, 92121 (US); Hussien, Faisal, San Diego, 92121 (US); Aboudina, Mohamed, San Diego, 92121 (US)
(74) Representative: Lippert Stachow Patentanwälte Rechtsanwälte Partnerschaft mbB

(57) **Abstract**

The invention discloses a polar transmitter apparatus comprising a modulator configured to create a series of complex valued IQ samples in time domain, a converter configured to convert the modulated IQ signals by the modulator into a polar representation of magnitude (AM) and phase (PM) information, an AM path configured to control an envelope of a generated radio frequency (RF) signal according to the AM information, a PM path configured to convert the PM information to an instantaneous frequency by differentiation over time, and a power amplifier (PA) configured to amplify the RF signal and send it to an antenna. The objective to define and specify a polar transmitter architecture that can support higher order modulation schemes with zero transitions will be solved therein that the apparatus comprises an AM sign extension block which is fed with the AM and PM information of the IQ-to-polar converter and the AM sign extension block is configured to detect a presence of a phase jump, to toggle hereupon a current sign to all samples on the AM path and subtract an equivalent phase from the PM path, the apparatus further comprises a sign extraction block configured to extract a sign information from the samples on the AM path and to convert the AM information back into an unsigned format and to provide sign control as a separate signal to the PA. (Fig. 7)

## Description

The invention relates to a polar transmitter apparatus comprising a modulator configured to create a series of complex valued IQ samples in time domain, a converter configured to convert the modulated IQ signals by the modulator into a polar representation of magnitude (AM) and phase (PM) information, an AM path configured to control an envelope of a generated radio frequency (RF) signal according to the AM information, a PM path configured to convert the PM information to an instantaneous frequency by differentiation over time, and a power amplifier (PA) configured to amplify the RF signal and send it to an antenna.

The invention also relates to a method performed by the inventive polar transmitter.

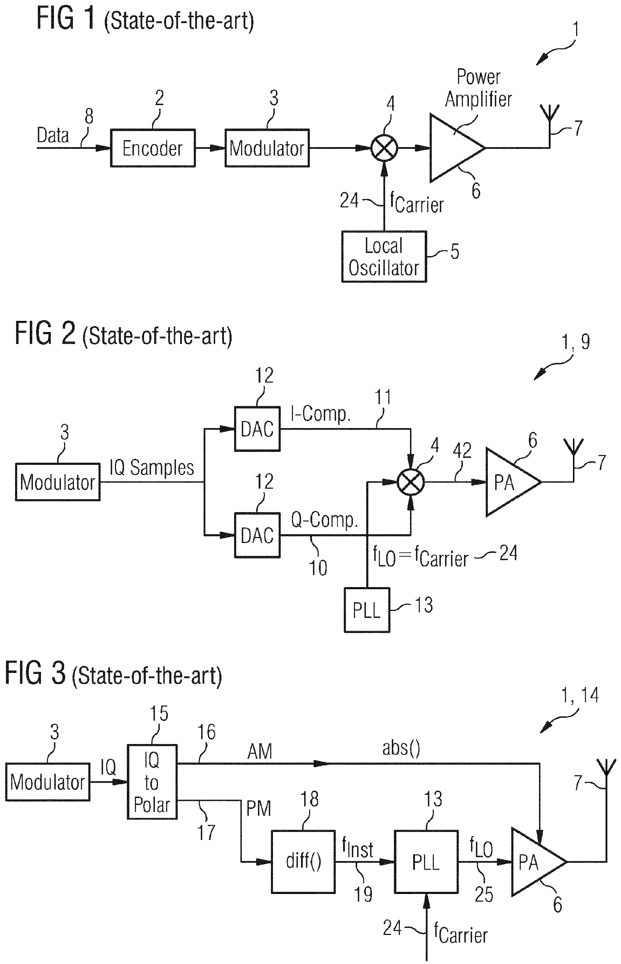

Systems for wireless communication usually possess at least one transmitter 1 to send encoded and modulated information across a wireless link. Such a transmitter 1 generally comprises the functional blocks encoder 2, modulator 3, local oscillator (LO) 5, mixer 4, and power amplifier (PA) 6, as shown in figure 1.

In figure 1 the encoder 2 applies a channel coding to the data 8 to be transmitted. The modulator 3 maps encoded channel bits to modulation symbols and creates a modulated signal in baseband. The LO 5 generates a signal with the radio frequency of the desired transmission channel, i. e. the so-called carrier frequency f_{carrier}. The mixer 4 is used to shift baseband signal to desired carrier frequency. Finally, the power amplifier 6 amplifies its input signal to the desired power level before sending the output signal to the antenna 7.

For such a transmitter (TX) 1, a so-called IQ architecture 9 is widely deployed, see figure 2. Here, the modulator 3 creates a series of complex valued samples in time domain. Each value is then split into real (Q) 10 and imaginary (I) 11 component and fed to dedicated digital-to-analog converters (DAC) 12. The resulting two signals are called in-phase or I-component 11 and quadrature-phase or Q-component 10. Same time, a local oscillator in form of a phase-locked loop (PLL) 13 creates the desired fixed channel frequency and feds it to the mixer 4, where I- and Q-component of the complex baseband signal are then converted to a real-valued RF signal centered around the carrier frequency. Finally, a PA 6 amplifies the RF signal and sends it to the antenna 7.

Many modern communication standards like Long Term Evolution (LTE), Narrowband Internet of Things (NB-IoT), Bluetooth Enhanced Data Rate (EDR), etc., define modulation schemes in terms of signals in IQ domain. Hence, transmission of such signals is tailored towards an IQ architecture in TX.

An alternative architecture for transmitters (TX) is the so-called polar architecture 14, see figure 3. Here, the modulated signal is converted into a polar representation by an IQ-to-polar converter 15, i.e. from real and imaginary component into magnitude 16 and phase 17. While magnitude information (AM) 16 is used to control the envelope of the generated RF signal, phase information (PM) 17 is converted to so-called instantaneous frequency 19 by differentiation 18 over time. The instantaneous frequency 19 is then used to modify frequency generation.

Polar TX architectures 14 provide some inherent advantages over more traditional IQ architectures 9, e. g. the absence of spurs created by the local oscillator 5, absence of problems due to various IQ mismatches, etc. However, said polar architecture approach also imposes additional challenges like PLL design.

The PLL 13 being used within a polar TX structure 14 must no longer generate a carrier frequency fixed in time but a time variant frequency carrying modulation information on top.

f_{LO}(t) = f_{carrier} + fᵢₙₛₜ(t), with f_{LO} being the frequency of the local oscillator 5 which is the sum of the carrier frequency f_{carrier} 24 and an instantaneous frequency finst 19.

Accuracy and resolution as well as difference between maximum and minimum (range) of instantaneous frequency have a big impact on PLL design. In general, it is difficult to design a PLL that supports a large range while providing fine resolution and high accuracy.

Considering polar transmitters and higher order modulation schemes:
As mentioned before, modern communication standards like Bluetooth EDR and NB-IoT describe modulation schemes in IQ domain, tailored towards an IQ architecture in transmitter implementation. Frequently, signals using higher order modulation schemes in those communication standards, e. g. EDR 8-DPSK mode in Bluetooth or 12-tone SC-FDMA (Single-carrier frequency-division multiple access) signals in NB-IoT, possess sections in the signal where the signal passes or even hits the origin (point [0; 0]) in IQ domain.

While not imposing a problem to IQ architecture based transmitters, such signals are challenging to polar transmitters. Main issue is that phase information PM(t) exhibits a strong gradient or even a jump which after differentiation results in a very high instantaneous frequency - up to ½ of the sampling frequency in a time-discrete system.

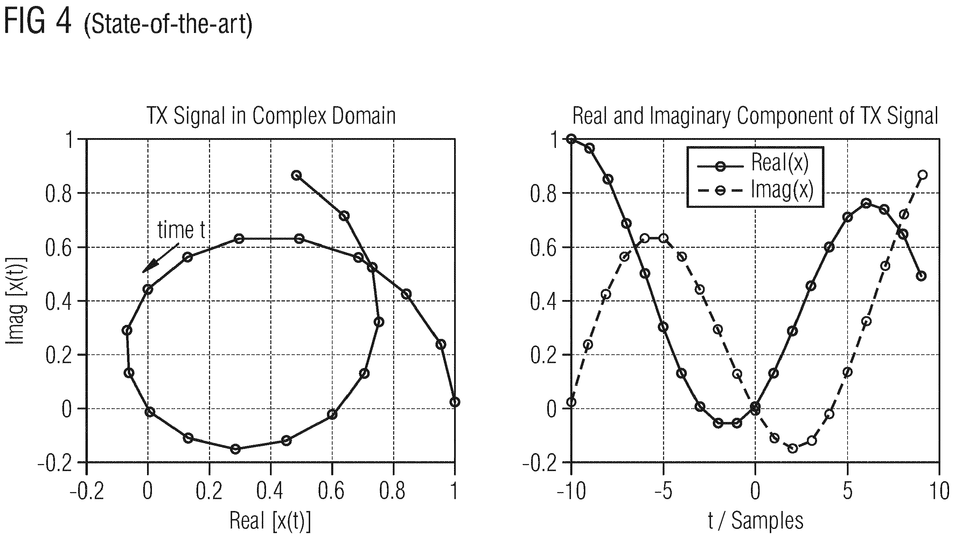

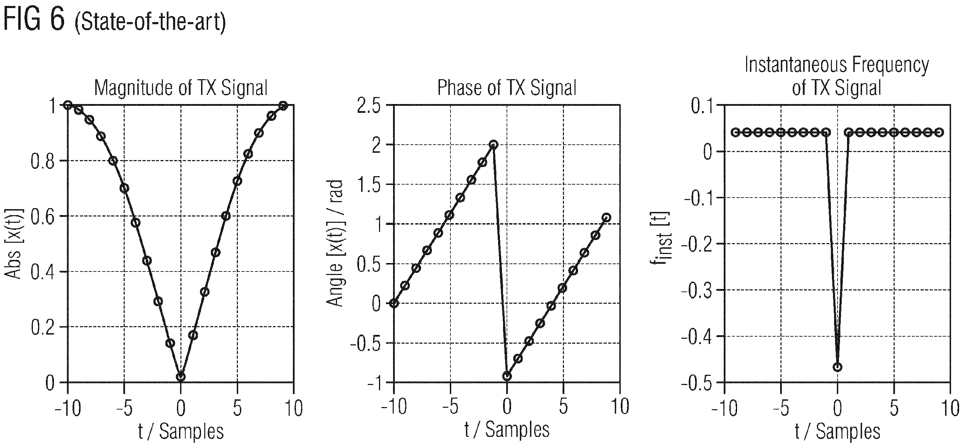

This behavior is illustrated in the examples shown in figure 4 for an IQ architecture transmitter and figure 6 for a polar transmitter architecture.

The left diagram in figure 4 shows such a signal transition in IQ domain. The right diagram in figure 4 shows the real and imaginary component over time - which are smooth in their individual realizations.

Figure 6 shows the corresponding plots in polar domain. The left diagram in figure 6 shows the magnitude over time with a distinct minimum at the time of interest. The middle diagram of figure 6 shows the phase over time with the obvious jump at the time of interest. Moreover, the right diagram of figure 6 shows the resulting instantaneous frequency with a clear minimum at the time of interest.

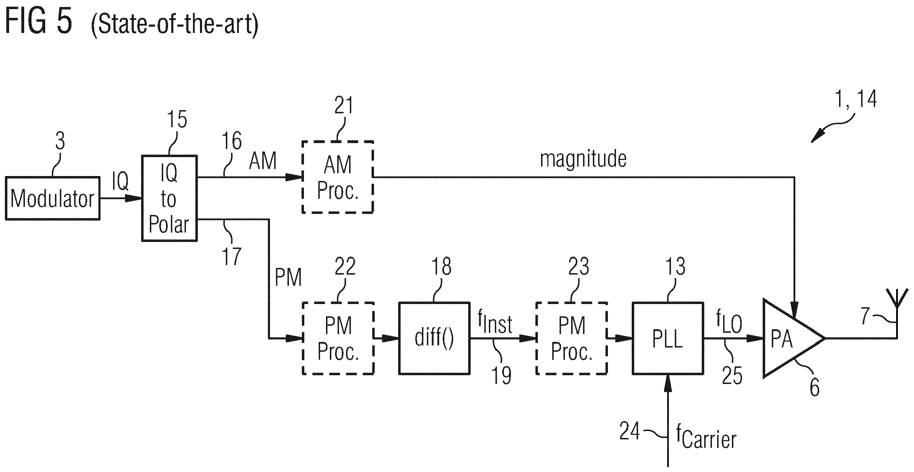

Figure 5 shows a more detailed architecture of a state-of-the-art polar transmitter architecture 14. The added processing blocks like the AM processing block 21, the PM processing block 22 and the FM processing block 23 represents optional processing steps for certain signals; e. g. look-up tables; such steps are not part of the invention but just represent placeholders.

It is evident that such signal transitions as shown in figure 6 determine the range for instantaneous frequency the PLL has to support in the polar TX architecture 14.

In state-of-the-art implementations of polar transmitters, there are techniques to limit the instantaneous frequency - either by adding time-variant offsets in complex IQ domain or by filtering, i. e. spreading of peaks in the instantaneous frequency over time. Both concepts however add error signals that degrade quality and spectral purity of the transmitted signal.

It is however difficult to design a PLL for polar TX that supports a large modulation frequency range while providing fine resolution and high accuracy. Most PLL designs provide a certain number of steps for fast frequency adjustments for modulation purposes, which means that the higher the supported frequency range, the bigger the individual step size becomes, leading to worse accuracy.

It is therefore the objective of the present invention to define and specify a polar transmitter architecture that can support higher order modulation schemes with zero transitions.

The objective will be solved by an apparatus according to independent claim 1.

The polar transmitter apparatus comprises a modulator configured to create a series of complex valued IQ samples in time domain, an IQ-to-polar converter configured to convert the modulated IQ signals by the modulator into a polar representation of magnitude (AM) and phase (PM) information, an AM path configured to control an envelope of a generated radio frequency (RF) signal according to the AM information, a PM path configured to convert the PM information to an instantaneous frequency by differentiation over time, and a power amplifier (PA) configured to amplify the RF signal and send it to an antenna. The inventive polar transmitter apparatus comprises an AM sign extension block which is fed with the AM and PM information outputted by the IQ-to-polar converter and the AM sign extension block is configured to detect a presence of a phase jump, to apply hereupon a current sign to all samples on the AM path and subtract a phase offset equivalent from the samples on the PM path, the apparatus further comprises a sign extraction block configured to extract a sign information from the samples on the AM path and to convert the AM information back into an unsigned format and to provide sign control as a separate signal to the PA.

The central idea of the inventive polar transmitter apparatus is to extend the AM path of the conventional polar transmitter architecture with the following blocks: an AM sign extension block, a sign extraction block and optionally a power amplifier with sign flip support. The inventive polar transmitter is modified to a signed format in order to realize fast phase changes and especially phase jumps by sign changes on the AM path instead of high frequency peaks of instantaneous frequency on a PLL modulation path.

This makes it possible to reduce the supported range for frequency modulation on the PLL within the polar transmitter architecture to half of the original range.

Furthermore, the modified architecture can be combined with other techniques, like adding time-variant offsets in complex IQ domain or filtering, for reduction of maximum instantaneous frequency, and hence allows for less strong filtering for instance with less degrades on quality and spectral purity of the transmitted signal.

In a variant of the inventive polar transmitter apparatus, the AM sign extension block comprises a delay element, a subtractor and an abs-block, all of them configured to compute an absolute value of a phase difference between two consecutive samples on the PM path, whereas the absolute value is compared with a configurable threshold and a current sign is applied to all samples on the AM path by a multiplier resulting in signed samples on the AM path, and the samples on the PM path are corrected by a phase offset equivalent to the current sign.

The advantage of using the AM sign extension block is that this block detects the presence of a phase jump. It toggles the sign of the samples on the AM path and simultaneously subtracts an equivalent phase from the samples on the PM path. In the sign extension block the numerical format of the AM path is extended from unsigned to signed, i. e. to form a format, which does not just support positive numbers but also negative numbers. Hence, the continuation of the amplitude information of the TX signal into negative range is much smoother. A phase jump over time can be removed for the transmitted signal and there a strong negative outlier in the resulting instantaneous frequency is no longer present.

In a further variant of the present inventive polar transmitter for a time-discrete system, the configurable threshold is in the range of (0,25...0,5)*fₛₐₘₚₗₑ, where fₛₐₘₚₗₑ is the frequency of the samples on the PM path. A threshold of < 0.25 would yield greater phase jumps after correction than the ones in the input signal and a threshold of 0.5 is equivalent to largest possible phase jump (on a full circle).

In another further variant of the inventive polar transmitter, a sign flag is toggled if the threshold is exceeded. Otherwise, the samples on the AM path remains their current sign.

In a variant of the inventive polar transmitter, the sign extraction block is configured to realize the mathematical functions x_{Envelope}(t) = abs (x_{AM}(t)) and x_{SignControl}(t) = sign (X_{AM}(t)), where x_{Envelope}(t) is the magnitude information of the samples on the AM path in time domain and x_{signcontrol}(t) is the sign information of the samples on the AM path in time domain. The samples on the AM or PM path forms and can be considered as an AM or PM data stream.

Depending on individual implementation, it is advantageous if the sign extraction may be merged into the power amplifier. If a certain functionality can be easily added to some existing circuitry, implementation effort and complexity decreases compared to an extra-dedicated block.

Therefore, in a variant of the inventive polar transmitter apparatus, the sign extraction block is merged into the power amplifier. The power amplifier will have a sign flip feature. In this newly introduced architecture, the PA will be used as an actuator for the sign change. PA designs relying on some state-of-the-art differential amplifier architecture are suitable to provide the additional functionality, whereas the existing amplifier circuitry is extended by a switching element. This element routes differential input signals either directly or in a flipped way to its outputs. The switch itself is controlled by a sign control signal. The sign control signal is outputted by the sign extraction block in the AM path.

In another variant of the inventive polar transmitter, the power amplifier is configured as an actuator for a sign change, whereas the power amplifier comprises a switching element before an operational amplifier, the switching element is configured to route differential input signals either directly or in a flipped way to the operational amplifier, whereas the switching element is controlled by a sign control signal outputted by the sign extraction block and the operational amplifier is controlled by the unsigned AM data stream outputted by the sign extraction block.

The sign extension block extends the numerical format of the AM path from unsigned to signed, i. e. to form a format, which does not just support positive numbers but also negative numbers. The sign control signal is formed in the sign extraction block, where a mathematical function sign() is implemented. The sign control signal triggers the switching element. The operational amplifier is controlled by the samples on the AM path that have been converted back into unsigned numerical format, whereas the conversion is done by an abs()-function implemented as an additional block in the sign extraction block.

The advantage of merging the sign extraction into the power amplifier is that by easily adding a certain functionality to some existing circuitry, implementation effort and complexity decreases compared to an extra-dedicated block.

The objective of the present invention will also be solved by a method for realizing fast phase changes and phase jumps in a polar transmitter apparatus performed by the apparatus according to claim 1 to 6, the method comprising the following steps:
- computing an absolute value of a phase difference between two consecutive samples on the PM path by a delay element, a subtractor and an abs-block computing the absolute value,
- comparing a result of the absolute value with a configurable threshold,
- toggling a sign flag, if the threshold is exceeded,
- applying a current sign to all samples on the AM path by a multiplier resulting in signed samples on the AM path,
- correcting the samples on the PM path by a phase offset equivalent to the current sign.

The invention will be explained in more detail using exemplary embodiments.

The appended drawings show
- Fig. 1: A well-known transmitter according to the state-of-the-art;
- Fig. 2: Signal treatment from modulator to the antenna in a conventional transmitter with IQ architecture according to the state-of-the-art;
- Fig. 3: Signal treatment from modulator to the antenna in a conventional transmitter with polar architecture according to the state-of-the-art;
- Fig. 4: a) Signal transition in complex domain, b) Real and imaginary component of the transmitted signal over time according to the state-of-the-art;
- Fig. 5: Signal treatment from modulator to the antenna in a conventional transmitter with polar architecture with optional processing steps according to the state-of-the-art;
- Fig. 6: Magnitude, Phase and instantaneous frequency of the transmitted signal over time in a polar transmitter architecture according to the state-of-the-art;
- Fig. 7: Signal treatment from modulator to the antenna in a transmitter with polar architecture according to the invention;
- Fig. 8: A block diagram of the AM sign extension according to the invention;
- Fig. 9: State-of-the-art power amplifier;
- Fig. 10: New power amplifier with sign flip support according to the invention;
- Fig. 11: Resulting signed magnitude, corrected phase and instantaneous frequency of the transmitted signal over time according to the invention.

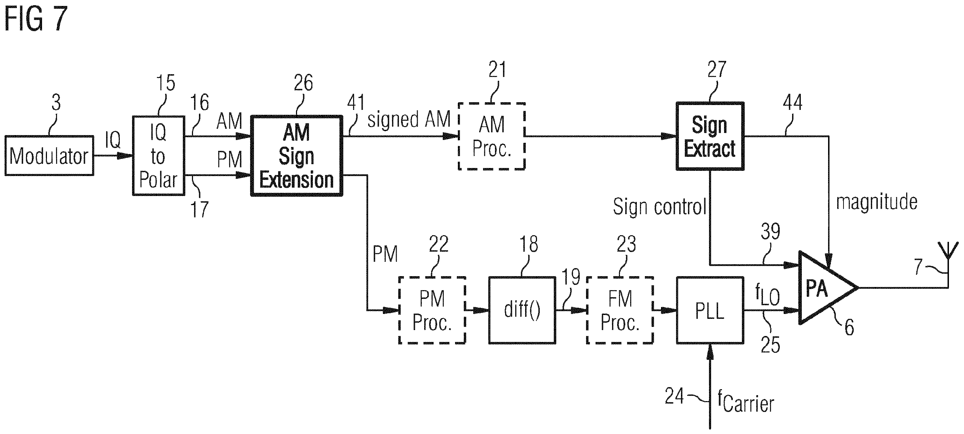

Figure 7 shows the newly proposed polar transmitter architecture with newly added or extended blocks marked with bold lines. Added blocks are the AM sign extension block 26, the sign extraction block 27 and the power amplifier 6 with sign flip support. The optional processing steps on the AM and PM path is to be executed on sign numbers instead of unsigned numbers compared to figure 5.

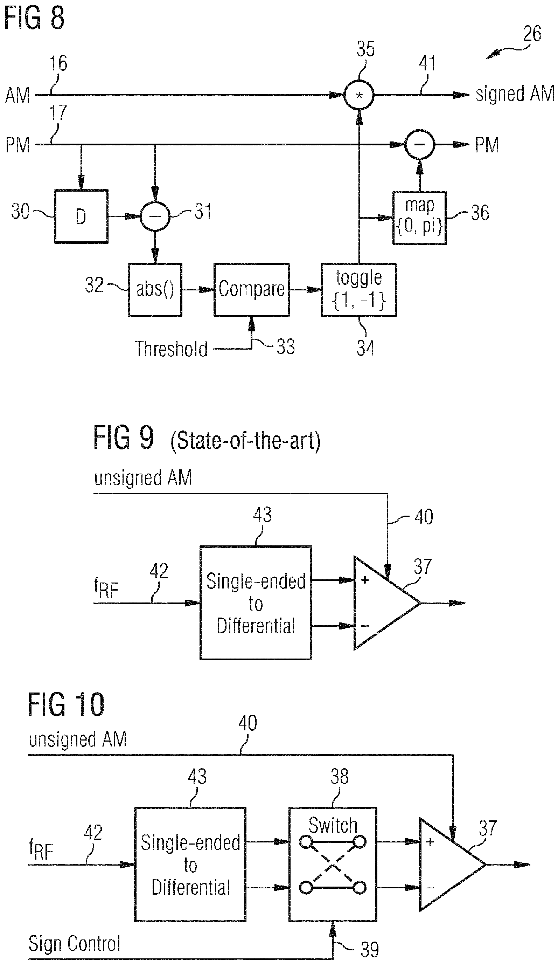

Figure 8 depicts a more detailed block diagram of the AM sign extension block 27. Functionally, this block 27 detects the presence of a phase jump, toggles the sign of the samples on the AM path and subtracts the equivalent phase from the samples on the PM path. First, the absolute of the phase difference between two consecutive samples is computed by means of a delay element 30, a subtractor 31 and an abs-block 32 computing the absolute value. The result is compared with a configurable threshold 33. If the threshold is exceeded, a sign flag is toggled 34.

Independent of any toggling event, the current sign is applied to all samples on the AM path 16 using a multiplier 35. Furthermore, the samples on the PM path 17 are corrected by the phase offset equivalent 36 to the current sign, i. e. by 0 for sign=+1 and by pi for sign=-1. In a time-discrete system, a useful range for the threshold is (0.25...0.5)*fsample.

Before providing information to the power amplifier 6 to control the envelope of the RF signal, it may be required to extract the sign information from the samples on the AM path 16, hence, from the AM data stream formed by the samples on the AM path, to convert the magnitude information back into an unsigned format and to provide sign control as a separate signal 39 to the PA 6. Formally, this block realizes following mathematical functions X_{Envelope}(t) = abs (x_{AM}(t)) and x_{SignControl}(t)= sign(x_{AM}(t)) .

Depending on individual implementation, sign extraction may be merged into PA. This is useful when a certain functionality can be easily added to some existing circuitry, because implementation effort and complexity decreases compared to an extra-dedicated block.

In an embodiment of the inventive polar transmitter 14, the PA 6 supports the sign flip by itself. In this newly introduced architecture, the PA 6 will be used as an actuator for the sign change. PA designs relying on some state-of-the-art differential amplifier architecture are suitable to provide the additional functionality. Figure 9 shows a simplified block diagram of such a state-of-the art PA. A single-ended to differential signal converter 43 connects blocks that handle/carry information/signals on one wire/line with fixed ground level being the reference, referred to as "single-ended", and blocks that handle/carry information/signals on two wires/lines where the information is conveyed as difference between levels of the two wires, irrespective of their individual relation to fixed ground level, referred to as "differential".

According to the invention, the existing well-known amplifier circuitry is extended by a switching element 38. This element 38 routes differential input signals either directly or in a flipped way to its outputs as shown in figure 10. The switch itself is controlled by the sign control signal 39, which is generated by the sign extraction block 27, in which the mathematical function sign() is implemented. The switching element is added to the path carrying the RF signal.

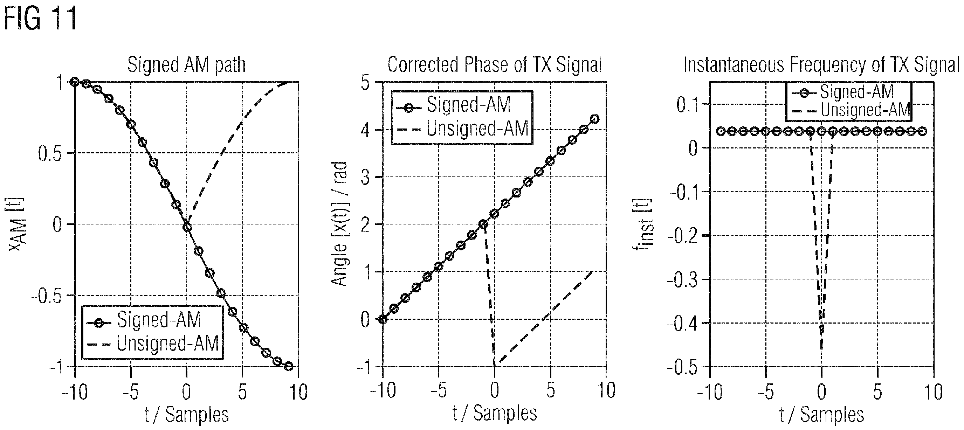

The diagrams in figure 11 show the effect of sign extension on AM and PM path. The left diagram in figure 11 shows the signal on the AM path 16 for the old and the new TX design. Particularly evident is the smooth continuation into negative range for the new TX design. The middle diagram in figure 11 shows the phase over time with the phase jump removed for the new TX design. Moreover, the right diagram in figure 11 shows the resulting instantaneous frequency where the strong negative outlier is no longer present.

### List of Reference Signs

- 1: transmitter
- 2: encoder
- 3: modulator
- 4: mixer
- 5: local oscillator
- 6: power amplifier
- 7: antenna
- 8: data tob e transmitted
- 9: IQ architecture
- 10: Q-component
- 11: I-component
- 12: Digital-to-analog converter
- 13: Phase-locked loop
- 14: Polar architecture
- 15: IQ-to-polar converter
- 16: AM path, magnitude information
- 17: PM path, phase information
- 18: Differential block
- 19: Instantaneous frequency
- 20: Phase locked loop
- 21: AM processing step
- 22: PM processing step
- 23: FM processing step
- 24: Carrier frequency
- 25: Local oscillator frequency
- 26: AM sign extension block
- 27: Sign extraction block
- 28: Sign control signal
- 29: Signed AM samples, signed AM data stream
- 30: Delay element
- 31: Subtrator
- 32: Abs-block
- 33: Threshold
- 34: Toggle
- 35: Multiplier
- 36: Phase mapping
- 37: Operational amplifier
- 38: Switching element
- 39: Sign control signal
- 40: Unsigned AM samples, unsigned AM data stream
- 41: Signed AM samples, signed AM data stream
- 42: Radio frequency (RF) signal
- 43: Single-ended to differential signal converter
- 44: magnitude of the AM data stream

## Claims

1. A polar transmitter apparatus (14)comprising a modulator (3) configured to create a series of complex valued IQ samples in time domain, an IQ-to-polar converter (15) configured to convert the modulated IQ signals by the modulator (3) into a polar representation of magnitude, AM, and phase, PM, information, an AM path (16) configured to control an envelope of a generated radio frequency, RF, signal by the AM information, a PM path (17) configured to convert the PM information to an instantaneous frequency by differentiation over time, and a power amplifier (6), PA, configured to amplify the RF signal (42) and send it to an antenna (7), **characterized in, that** the apparatus comprises an AM sign extension block (26) which is fed with the AM and PM information of the IQ-to-polar converter (15) and the AM sign extension block (26) is configured to detect a presence of a phase jump, to toggle hereupon a current sign to all samples on the AM path (16) and subtract an equivalent phase from the PM path (17), the apparatus further comprises a sign extraction block (27) configured to extract a sign information from the samples on the AM path (16) and to convert the AM information back into an unsigned format and to provide sign control (26) as a separate signal to the PA (6).

2. The polar transmitter apparatus according to claim 1, **characterized in, that** the AM sign extension block (26) comprises a delay element (30), a subtractor (31) and an abs-block (32), all of them configured to compute an absolute value of a phase difference between two consecutive samples on the PM path (17), whereas the absolute value is compared with a configurable threshold (33) and a current sign is applied to all samples on the AM path (16) by a multiplier (35) resulting in signed samples (41) on the AM path (16), and the samples on the PM path (17) are corrected by a phase offset equivalent (36) to the current sign.

3. The polar transmitter apparatus according to claim 2, **characterized in, that** in a time-discrete system the configurable threshold (33) is in the range of (0,25...0,5)*fₛₐₘₚₗₑ, where fₛₐₘₚₗₑ is the frequency of the samples on the PM path (17).

4. The polar transmitter apparatus according to claims 2 or 3, **characterized in, that** if the threshold (33) is exceeded, a sign flag is toggled (34).

5. The polar transmitter apparatus according to claim 1, **characterized in, that** the sign extraction block (27) is configured to realize the mathematical functions X_{Envelope}(t) = abs(x_{AM}(t)) and x_{SignControl}(t)= sign(x_{AM}(t)), where x_{Envelope}(t) is the magnitude information (44) of an AM data stream on the AM path (16) in time domain and x_{SignControl}(t) is the sign information (39) of the AM data stream on the AM path (16) in time domain.

6. The polar transmitter apparatus according to claim 1, **characterized in, that** the power amplifier (6) is configured as an actuator for a sign change, whereas the power amplifier comprises a switching element (38) before an operational amplifier (37), the switching element (38) is configured to route differential input signals either directly or in a flipped way to the operational amplifier (37), whereas the switching element (38) is controlled by a sign control signal (39) outputted by the sign extraction block (27) and the operational amplifier (37) is controlled by the unsigned AM data stream (40) outputted by the sign extraction block (27).

7. A method for realizing fast phase changes and phase jumps in a polar transmitter apparatus performed by the apparatus according to claim 1 to 6, **characterized in, that** the method comprising the following steps:
- computing an absolute value of a phase difference between two consecutive samples on the PM path (17) by a delay element (30), a subtractor (31) and abs-block (32) computing the absolute value,
- comparing a result of the absolute value with a configurable threshold (33),
- toggling (34) a sign flag, if the threshold (33) is exceeded,
- applying a current sign to all samples on the AM path by a multiplier (35) resulting in signed samples (41) on the AM path (16),
- correcting (36) the samples on the PM path (17) by a phase offset equivalent to the current sign.
